# EUROPEAN PATENT APPLICATION

(11) **EP 4 811 661 A1**
(43) Date of publication of application: **23.09.2026**
(21) Application number: 26165832.2
(22) Date of filing: 18.03.2026
(51) Int. Cl.: H03K 17/0812

(54) **POWER MODULE AND POWER SUPPLY DEVICE**

(30) Priority: 20.03.2025 CN 202510337737
(71) Applicant: HUAWEI TECHNOLOGIES CO., LTD., Shenzhen 518129 (CN)
(72) Inventor: CHEN, Jialuo, Shenzhen, 518129 (CN); WANG, Minglong, Shenzhen, 518129 (CN); ZHAO, Jijian, Shenzhen, 518129 (CN); LU, Liyuan, Shenzhen, 518129 (CN)
(74) Representative: Gill Jennings & Every LLP

(57) **Abstract**

Embodiments of this application provide a power module and a power supply device. The power module includes a half-bridge circuit and a driver. The half-bridge circuit includes two serially connected power transistors, and the two power transistors do not share a ground. The driver includes two drive parts. One of the drive parts is configured to drive one of the power transistors, and a circuit in which the one drive part is located shares a ground with the one corresponding power transistor. The power module further includes two first resistors connected in series and a power supply, and each drive part includes a power input end, a high-voltage signal transmission end, and a voltage output end. One end of the power supply is connected to the high-voltage signal transmission end by using the power input end, the other end of the power supply is grounded, the high-voltage signal transmission end is further grounded by using the two first resistors connected in series, and a voltage of the high-voltage signal transmission end is used to drive one of the power transistors to be turned on. The voltage output end is connected to a connection point between the two first resistors connected in series, and the voltage output end is configured to output a voltage to the connection point.

## Description

### TECHNICAL FIELD

This application relates to the circuit field, and more specifically, to a power module and a power supply device.

### BACKGROUND

As an important component of a power module, a power conversion circuit is usually configured to convert energy of an input power supply to an output form required by a load, for example, convert an alternating current to a direct current (alternating current-direct current, AC-DC), convert a direct current to a direct current (direct current-direct current, DC-DC), or convert a direct current to an alternating current (direct current-alternating current, DC-AC).

Currently, the power conversion circuit in the power module uses a half-bridge circuit design in most cases. A half-bridge circuit mainly includes two serially connected power transistors, and the two power transistors are alternately turned on during operation of the power conversion circuit. However, during practical application, different power transistors require different drive voltages during turn-on, and a driver disposed in the current power module can generally provide only a fixed drive voltage, failing to adequately meet different requirements on the drive voltages of the different power transistors during turn-on.

### SUMMARY

This application provides a power module and a power supply device, so that a drive voltage provided by a driver for a power transistor can be flexibly adjusted, to meet different requirements on drive voltages of different power transistors during turn-on.

According to a first aspect, a power module is provided, where the power module includes a half-bridge circuit and a driver. The half-bridge circuit includes two serially connected power transistors, and the two power transistors do not share a ground. The driver includes two drive parts. One of the drive parts is configured to drive one of the power transistors, and a circuit in which the drive part is located shares a ground with the one corresponding power transistor. The power module further includes two first resistors connected in series and a power supply, and each drive part includes a power input end, a high-voltage signal transmission end, and a voltage output end. One end of the power supply is connected to the high-voltage signal transmission end by using the power input end, the other end of the power supply is grounded, the high-voltage signal transmission end is further grounded by using the two first resistors connected in series, and a voltage of the high-voltage signal transmission end is used to drive one of the power transistors to be turned on. The voltage output end is connected to a connection point between the two first resistors connected in series, and the voltage output end is configured to output a voltage to the connection point.

Based on the foregoing design, when any one of the drive parts in the driver needs to drive a power transistor corresponding to the drive part to be turned on, the power supply may form, by using the power input end and the high-voltage signal transmission end that are in any one of the drive parts, a ground loop with the two first resistors connected in series, and the voltage output end in any one of the drive parts may output the voltage to the connection point between the two first resistors in the ground loop. In the foregoing ground loop, the voltage of the high-voltage signal transmission end is used as a drive voltage for driving the power transistor to be turned on. Because the two first resistors are connected in series for voltage division in the ground loop, at least one of the voltage that is output by the voltageoutput end to the connection point between the two first resistors and a resistance ratio of the two first resistors is adjusted, so that the voltage of the high-voltage signal transmission end can be flexibly adjusted, that is, a drive voltage provided by any one of the drive parts for the power transistor corresponding to the drive part can be flexibly adjusted. In this way, the drive voltage provided by any one of the drive parts for the power transistor corresponding to the drive part may meet different requirements on drive voltages of different power transistors during turn-on.

In an implementation, at least one of the drive parts further includes a load end, and the load end is grounded by using a load in the power module. The load end is configured to receive, by using a power input end in the drive part in which the load end is located, a voltage that is output by the power supply, and transmit the received voltage to the load.

Based on the foregoing design, the driver may be used as a power supply, and supplies power to a load near the driver by using the load end disposed on the driver. In this way, this not only facilitates power supply to the load, but also may increase a utilization rate of the driver.

In an implementation, each drive part further includes a high-voltage signal output end, a first switch circuit, and a drive signal input end, the high-voltage signal output end is connected to the high-voltage signal transmission end through the first switch circuit, and the high-voltage signal output end is further connected to a control end of the one power transistor. The high-voltage signal output end is configured to send, to the one power transistor, a signal indicating a voltage of the high-voltage signal transmission end. The first switch circuit is configured to: when the drive signal input end receives a high-level signal, turn on a circuit between the high-voltage signal output end and the high-voltage signal transmission end; or when the drive signal input end receives a low-level signal, turn off a circuit between the high-voltage signal output end and the high-voltage signal transmission end.

Based on the foregoing design, based on indications of the high-level signal and the low-level signal that are received by the drive signal input end in any one of the drive parts, a first switch in any one of the drive parts may turn on or off the circuit between the high-voltage signal transmission end and the high-voltage signal output end, so that a circuit between the high-voltage signal transmission end and the control end of the power transistor is turned on or off. In this way, it may be ensured that any one of the drive parts drives the power transistor to be normally turned on or off. In addition, the high-voltage signal transmission end is connected to the control end of the power transistor by using the first switch circuit and the high-voltage signal output end that are located in the drive part in which the high-voltage signal transmission end is located, so that the driver controls turn-on/turn-off of the circuit between the high-voltage signal transmission end and the control end of the power transistor. Compared with a case in which the high-voltage signal transmission end is connected to the control end of the power transistor through a switch circuit disposed outside the driver, this can reduce complexity and control logic of a circuit design in the power module.

In an implementation, the power module further includes a magnetic device, and the high-voltage signal output end is connected to the control end of the one power transistor by using the magnetic device. A length of a transmission line between the magnetic device and the control end of the one power transistor is less than a length of a transmission line between the magnetic device and the high-voltage signal output end.

Based on the foregoing design, the magnetic device connected between the driver and the half-bridge circuit may be disposed closer to the power transistor in the half-bridge circuit. In this way, drive oscillation of the power transistor may be better suppressed by using the magnetic device.

In an implementation, the half-bridge circuit includes a plurality of groups of two serially connected power transistors, the plurality of groups of two serially connected power transistors are connected in parallel, and a plurality of connection points formed between the two power transistors in the plurality of groups of two serially connected power transistors are connected. There is one magnetic device, and the high-voltage signal output end is connected to the control end of the one power transistor in each group of two power transistors by using the magnetic device. A length of a transmission line between the magnetic device and each control end connected to the magnetic device is less than a length of a transmission line between the magnetic device and the high-voltage signal output end.

Based on the foregoing design, the high-voltage signal output end may be connected to one power transistor in each group of two serially connected power transistors in the half-bridge circuit by using one magnetic device, and the magnetic device is disposed closer to the power transistor that is connected to the magnetic device and that is in each group of two serially connected power transistors. In this way, not only drive oscillation of the power transistor that is connected to the magnetic device and that is in each group of two serially connected power transistors may be better suppressed by using the magnetic device, but also oscillation crosstalk generated between the plurality of groups that are connected in parallel and that are of two serially connected power transistors can be suppressed. In addition, a small quantity of magnetic devices may alternatively be used in the power module, thereby facilitating cost optimization of the power module.

In an implementation, the half-bridge circuit includes a plurality of groups of two serially connected power transistors, the plurality of groups of two serially connected power transistors are connected in parallel, and a plurality of connection points formed between the two power transistors in the plurality of groups of two serially connected power transistors are connected. There are a plurality of magnetic devices, and the high-voltage signal output end is connected to the control end of the one power transistor in one group of power transistors by using one of the magnetic devices. A length of a transmission line between the one magnetic device and the control end connected to the one magnetic device is less than a length of a transmission line between the one magnetic device and the high-voltage signal output end.

Based on the foregoing design, the high-voltage signal output end may be separately connected, by using the plurality of magnetic devices, to one power transistor in the plurality of groups of two serially connected power transistors, and each magnetic device is disposed closer to the power transistor connected to the magnetic device. In this way, not only drive oscillation of the power transistor that is connected to the magnetic device and that is in each group of two serially connected power transistors may be better suppressed by using the plurality of magnetic devices, but also oscillation crosstalk generated between the plurality of groups that are connected in parallel and that are of two serially connected power transistors can be suppressed. In addition, because one power transistor in each group of two serially connected power transistors is connected to different magnetic devices, normal operation of another magnetic device may be prevented from being affected because a fault occurs on one magnetic device.

In an implementation, each drive part further includes a low-voltage signal output end, a low-voltage signal transmission end, and a second switch circuit. The low-voltage signal transmission end is connected to the one end of the power supply by using the power input end, the low-voltage signal transmission end is further connected to the low-voltage signal output end through the second switch circuit, and the low-voltage signal output end is connected to the control end of the one power transistor. The low-voltage signal output end is configured to send, to the one power transistor, a signal indicating a voltage of the low-voltage signal transmission end, where the voltage of the low-voltage signal transmission end is used to drive one of the power transistors to be turned off. The second switch circuit is configured to: when the drive signal input end receives a low-level signal, turn on a circuit between the low-voltage signal transmission end and the low-voltage signal output end; and when the drive signal input end receives a high-level signal, turn off the circuit between the low-voltage signal transmission end and the low-voltage signal output end.

Based on the foregoing design, when any one of the drive parts in the driver needs to drive a power transistor corresponding to the drive part to be turned off, the power supply may transmit the voltage to the low-voltage signal transmission end by using the power input end in any one of the drive parts, and the second switch circuit may turn on the circuit between the low-voltage signal transmission end and the low-voltage signal output end Further, the low-voltage signal output end may transmit the voltage of the low-voltage signal transmission end to the control end of the power transistor, to drive the power transistor to be turned off.

In an implementation, the power module further includes a plurality of capacitors. The high-voltage signal transmission end is connected, by using one end of one of the capacitors, to the two first resistors connected in series, and the other end of the one capacitor is grounded. The low-voltage signal transmission end is grounded by using another capacitor.

Based on the foregoing design, filtering may be performed and loop stability may be maintained by using the grounded capacitor, thereby improving reliability of running of the power module.

In an implementation, the power module further includes a plurality of second resistors, and the high-voltage signal output end and the low-voltage signal output end are separately connected to the control end of the one power transistor by using one of the second resistors.

Based on the foregoing design, a speed at which the high-voltage signal output end and the low-voltage signal output end in any one of the drive parts connected to the second resistor transmit a drive voltage to the control end of the corresponding power transistor may be adjusted by using the second resistor, so that it can be ensured that any one of the drive parts stably drives the corresponding power transistor to be turned on or off.

According to a second aspect, a power supply device is provided. The power supply device includes a plurality of power modules according to any one of the first aspect, the plurality of power modules are connected in parallel, and the plurality of power modules are configured to supply power to a load.

It should be understood that for specific descriptions of the technical effects of the second aspect, reference may be made to the related descriptions of the technical effects of the first aspect. Details are not described herein again.

### BRIEF DESCRIPTION OF DRAWINGS

FIG. 1 is a diagram of a structure of a power supply device according to an embodiment of this application;
FIG. 2 is a diagram of a structure of a power module according to an embodiment of this application;
FIG. 3 is a diagram of a structure of another power module according to an embodiment of this application; and
FIG. 4 is a diagram of a structure of still another power module according to an embodiment of this application.

### DESCRIPTION OF EMBODIMENTS

For ease of understanding of embodiments of this application, the following descriptions are first provided before embodiments of this application are described.

In the descriptions of embodiments of this application, a connection may be an electrical connection. The electrical connection may be understood as that signal transmission is implemented between two electrical elements through a direct electrical connection or an indirect electrical connection. For example, that A is electrically connected to B may be understood as that A is directly electrically connected to B, or may be understood as that A is indirectly electrically connected to B through one or more other electronic components.

The terms "first" and "second" in embodiments of this application are merely intended for a purpose of description, and shall not be understood as an indication or implication of relative importance or implicit indication of a quantity of indicated technical features. Therefore, a feature limited by "first " or "second" may explicitly indicate or implicitly include one or more such features. In addition, in the descriptions of embodiments of this application, "a plurality of" means two or more, and "at least one" and "one or more" mean one, two, or more.

The following describes technical solutions of this application with reference to accompanying drawings.

First, for ease of understanding the technical solutions provided in embodiments of this application, an application scenario to which embodiments of this application are applicable is first described.

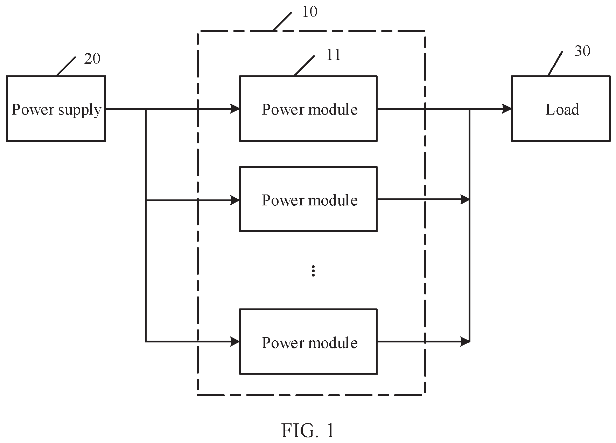

FIG. 1 is a diagram of a structure of a power supply device 10 according to an embodiment of this application.

As shown in FIG. 1, the power supply device 10 includes a plurality of power modules 11 connected in parallel. Inputs of the plurality of power modules 11 are configured to connect to a power supply 20, and outputs of the plurality of power modules 11 are configured to connect to a load 30. Each of the power modules 11 includes a power conversion circuit. The power conversion circuit is configured to convert, to an electric energy form required by the load 30, electric energy that is output by the power supply 20, and then output the electric energy to the load 30, to supply power to the load 30.

It should be understood that, in this embodiment of this application, the power supply device 10 may be a device configured to provide electric energy in a scenario such as a communication base station, an energy storage system, a photovoltaic system, a data center, or a charging station. For example, the power supply device 10 may be a power cabinet in the communication base station, and correspondingly, the load 30 may be an electrical apparatus such as a radio remote unit (remote radio unit, RRU), an active antenna unit (active antenna unit, AAU), or a baseband processing unit (base band processing unite, BBU) in the communication base station. For another example, the power supply device 10 may alternatively be a charging pile in the charging station, and correspondingly, the load 30 may be an electric vehicle.

It should further be understood that, in this embodiment of this application, the power module 11 may be a power converter in the power supply device 10.

For example, in an example, when the power supply 20 is an alternating-current power supply, the power conversion circuit in the power module 11 may be configured to convert, to a direct current, an alternating current that is output by the alternating-current power supply, and output the direct current to the load 30. That is, the power module 11 may be a rectifier, and the power conversion circuit may be a power factor correction (power factor correction, PFC) circuit.

In another example, when the power supply 20 is a direct-current power supply, the power conversion circuit in the power module 11 may be configured to perform voltage conversion on a direct current that is output by the direct-current power supply, and output a converted direct current to the load 30. That is, the power module 11 may be a DC-DC converter, and the power conversion circuit may be a DC-DC conversion circuit. Alternatively, the power conversion circuit in the power module 11 may be configured to convert, to an alternating current, a direct current that is output by a direct-current power supply, and output the alternating current. That is, the power module 11 may be an inverter, and the power conversion circuit may be an inverter circuit.

As described in the foregoing background, the power conversion circuit in the power module 11 uses a half-bridge circuit design in most cases. A half-bridge circuit mainly includes two serially connected power transistors. During operation of the power conversion circuit, the two power transistors are alternately turned on. However, during actual application, different power transistors require different drive voltages during turn-on. For example, when the power transistor is made of a gallium nitride material, a drive voltage required by the power transistor during turn-on is generally 6 V. For another example, when the power transistor is made of a silicon material, a drive voltage required by the power transistor during turn-on is generally 12 V. However, in the current power module 11, a driver generally can provide only a fixed drive voltage. As a result, compatibility of the driver is poor, failing to adequately meet different requirements on drive voltages of different power transistors during turn-on.

Based on the foregoing content, an embodiment of this application provides a power module. The power module includes a half-bridge circuit and a driver. The half-bridge circuit includes two serially connected power transistors, and the two power transistors do not share a ground. The driver includes two drive parts. One of the drive parts is configured to drive one of the power transistors, and a circuit in which the one drive part is located shares a ground with the power transistor corresponding to the drive part. In addition, the power module further includes two first resistors connected in series and a power supply, and each drive part includes a power input end, a high-voltage signal transmission end, and a voltage output end. One end of the power supply is connected to the high-voltage signal transmission end by using the power input end, the other end of the power supply is grounded, the high-voltage signal transmission end is further grounded by using the two first resistors connected in series, and a voltage of the high-voltage signal transmission end is used to drive a corresponding power transistor to be turned on. The voltage output end is connected to a connection point between the two first resistors connected in series, and the voltage output end is configured to output a voltage to the connection point.

Based on the foregoing design, when any one of the drive parts in the driver is configured to drive a corresponding power transistor in the half-bridge circuit to be turned on, the power supply may form, by using the power input end and the high-voltage signal transmission end that are in any one of the drive parts, a ground loop with the two first resistors connected in series, and the voltage output end in any one of the drive parts may output a voltage to the connection point between the two first resistors in the ground loop. In the foregoing ground loop, the voltage of the high-voltage signal transmission end is used as a drive voltage for driving the power transistor to be turned on. Because the two first resistors are connected in series for voltage division in the ground loop, at least one of the voltage that is output by the voltage output end to the connection point between the two first resistors and a resistance ratio of the two first resistors is adjusted, so that the voltage of the high-voltage signal transmission end can be flexibly adjusted, that is, a drive voltage provided by any one of the drive parts for the power transistor corresponding to the drive part can be flexibly adjusted. In this way, the drive voltage provided by any one of the drive parts for the power transistor corresponding to the drive part may meet different requirements on drive voltages of different power transistors during turn-on.

It should be understood that the power module provided in this embodiment of this application may be a power converter such as a rectifier, a DC-DC converter, or an inverter. The power module provided in this embodiment of this application may be applied to a power supply device in a scenario such as a communication base station, an energy storage system, a photovoltaic system, a data center, or a charging station, for example, applied to the power supply device 10 shown in FIG. 1. Alternatively, the power module provided in this embodiment of this application may further be applied to an electrical apparatus such as an RRU, an AAU, or a BBU in the communication base station.

The following describes the power module provided in embodiments of this application with reference to the accompanying drawings.

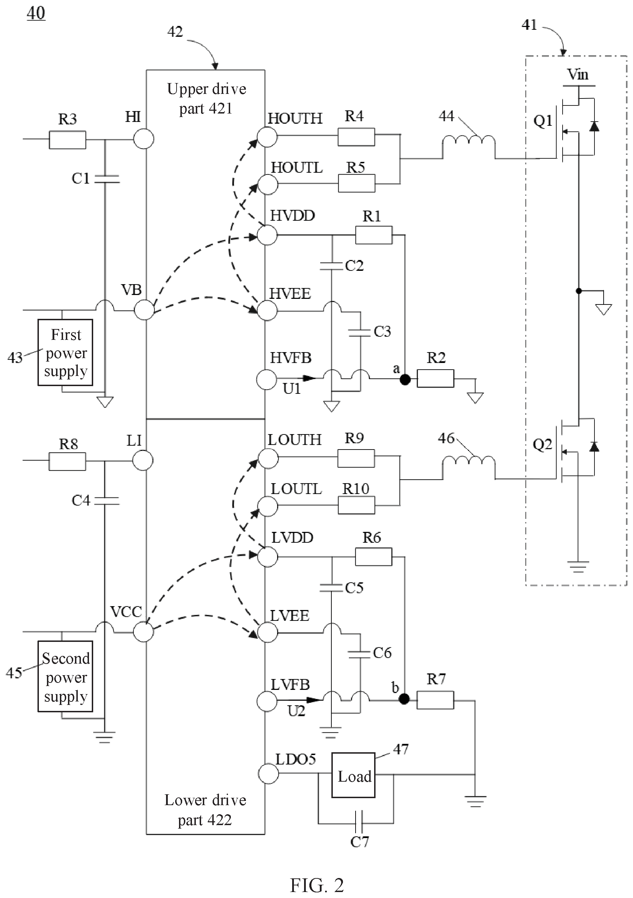

FIG. 2 is a diagram of a structure of a power module 40 according to an embodiment of this application.

As shown in FIG. 2, the power module 40 includes a half-bridge circuit 41. The half-bridge circuit 41 includes two serially connected power transistors, and the two power transistors do not share a ground. That is, ground ends of the two power transistors are not connected together.

Specifically, as shown in FIG. 2, for example, the half-bridge circuit 41 includes an upper power transistor Q1 and a lower power transistor Q2 that are connected in series. A drain of the upper power transistor Q1 is configured to connect to an input power supply Vin, a source of the upper power transistor Q1 is connected to a drain of the lower power transistor Q2, and the source of the upper power transistor Q1 and a source of the lower power transistor Q2 are also connected to different reference grounds, respectively. In this way, the upper power transistor Q1 and the lower power transistor Q2 are alternately turned on, so that power conversion can be performed on electric energy that is output by the input power supply Vin before outputting.

It should be understood that, in this embodiment of this application, the power transistor may be a plurality of types of power switching transistors such as a metal-oxide-semiconductor field-effect transistor (metal-oxide-semiconductor field-effect transistor, MOSFET), a bipolar junction transistor (bipolar junction transistor, BJT), and an insulated gate bipolar transistor (insulated gate bipolar transistor, IGBT). For ease of description and understanding, an example in which the power transistor is a MOSFET is used for description in this embodiment of this application. In addition, the power transistor may be made of a material such as gallium nitride, silicon carbide, or silicon.

Still as shown in FIG. 2, the power module 40 further includes a driver 42, and the driver 42 includes two drive parts, that is, an upper drive part 421 and a lower drive part 422.

The upper drive part 421 is connected to a control end of the upper power transistor Q 1. For example, when the upper power transistor Q1 is a MOSFET, the upper drive part 421 is connected to a gate of the upper power transistor Q1, and is configured to provide a drive voltage to the gate of the upper power transistor Q1, to drive the upper power transistor Q1 to be turned off or on. Similarly, the lower drive part 422 is connected to a control end of the lower power transistor Q2, and is configured to provide a drive voltage to the control end of the lower power transistor Q2, to drive the lower power transistor Q2 to be turned on or off.

In addition, a circuit in which the upper drive part 421 is located shares a ground with the upper power transistor Q1, and a circuit in which the lower drive part 422 is located shares a ground with the lower power transistor Q2. That is, similar to the upper power transistor Q1 and the lower power transistor Q2, a ground end of the circuit in which the upper drive part 421 is located is not connected to a ground end of the circuit in which the lower drive part 422 is located, and the two drive parts are isolated from each other. In this way, the two drive parts may independently perform driving control on the two power transistors without affecting each other.

The following first describes a related structure of the upper drive part 421 by using the upper drive part 421 in the driver 42 as an example.

In some embodiments, as shown in FIG. 2, the power module 40 further includes a first power supply 43, and the upper drive part 421 includes a power input end VB and a drive signal input end HI. One end of the first power supply 43 is connected to the power input end VB, and the other end of the first power supply 43 is grounded. The first power supply 43 is configured to supply power to the upper drive part 421 by using the power input end VB, to ensure normal operation of the upper drive part 421.

In addition, the drive signal input end HI is configured to receive a high-level signal or a low-level signal, for example, receive a high-level signal or a low-level signal sent by a digital signal processor in the power module 40. The high-level signal indicates the upper drive part 421 to drive the upper power transistor Q1 to be turned on, and the low-level signal indicates the upper drive part 421 to drive the upper power transistor Q1 to be turned off.

In some embodiments, as shown in FIG. 2, the power module 40 further includes a first resistor R1 and a first resistor R2 that are connected in series, and the upper drive part 421 further includes a high-voltage signal transmission end HVDD. The high-voltage signal transmission end HVDD is connected to an end of the first power supply 43 by using the power input end VB, and the high-voltage signal transmission end HVDD is further grounded by using the first resistor R1 and the second resistor R2 that are connected in series.

Based on the foregoing design, when the drive signal input end HI receives the high-level signal, the first power supply 43 may supply power to the high-voltage signal transmission end HVDD by using the power input end VB, so that a ground loop is formed between the first power supply 43, the high-voltage signal transmission end HVDD, the first resistor R1, and the first resistor R2. In the ground loop, a voltage U_{Hupper} of the high-voltage signal transmission end HVDD is used to drive the upper power transistor Q1 to be turned on. That is, the voltage U_{Hupper} is a drive voltage used to drive the upper power transistor Q1 to be turned on.

During specific implementation, the high-voltage signal transmission end HVDD may directly transmit, to the control end of the upper power transistor Q1, a signal indicates the voltage of the high-voltage signal transmission end HVDD, to drive the upper power transistor Q1 to be turned on. Alternatively, the high-voltage signal transmission end HVDD may transmit, to the control end of the upper power transistor Q1 by using another connection end disposed on the upper drive part 421, a signal indicates the voltage of the high-voltage signal transmission end HVDD.

In some embodiments, still as shown in FIG. 2, the upper drive part 421 further includes a voltage output end HVFB. The voltage output end HVFB is connected to a connection point a between the first resistor R1 and the first resistor R2, and the voltage output end HVFB is configured to output a voltage to the connection point a. During specific implementation, the voltage output end HVFB may receive, by using the power input end VB, a voltage that is output by the first power supply 43, and output the received voltage to the connection point a.

Based on the foregoing design, when the drive signal input end HI receives the high-level signal, and the first power supply 43 forms a ground loop with the high-voltage signal transmission end HVDD, the first resistor R1, and the first resistor R2 by using the power input end VB, the voltage output end HVFB may output a voltage to the connection point a in the ground loop.

For example, when the voltage output end HVFB outputs a voltage U1 to the connection point a, because the first resistor R1 and the first resistor R2 are connected in series for voltage division, in the ground loop, the voltage U_{H} of the high-voltage signal transmission end HVDD = U1 (R1 + R2)/R2. In this way, during actual application, at least one of the voltage U1 that is output by the voltage output end HVFB and a resistance ratio of the first resistor R1 to the first resistor R2 is adjusted, so that the voltage U_{Hupper} of the high-voltage signal transmission end HVDD can be flexibly adjusted, that is, the drive voltage transmitted by the upper drive part 421 to the control end of the upper power transistor Q1 is flexibly adjusted. In this way, the drive voltage provided by the upper drive part 421 to the upper power transistor Q1 can meet a turn-on requirement of the upper power transistor Q1, the foregoing manner of adjusting the upper drive part 421 to provide the drive voltage to the upper power transistor Q1 is simple, and flexible control is easily implemented.

In some embodiments, as shown in FIG. 2, the upper drive part 421 further includes a high-voltage signal output end HOUTH and a first switch circuit (not shown in the figure). The high-voltage signal output end HOUTH is connected to the high-voltage signal transmission end HVDD through the first switch circuit. The first switch circuit is configured to: when the drive signal input end HI receives a high-level signal, turn on a circuit between the high-voltage signal transmission end HVDD and the high-voltage signal output end HOUTH. The first switch circuit is further configured to: when the drive signal input end HI receives a low-level signal, turn off a circuit between the high-voltage signal transmission end HVDD and the high-voltage signal output end HOUTH.

In addition, the high-voltage signal output end HOUTH is further connected to the control end of the upper power transistor Q1, and the high-voltage signal output end HOUTH is configured to send, to the control end of the upper power transistor Q1, a signal indicates a voltage U_{H} of the high-voltage signal transmission end HVDD.

Based on the foregoing design, when the upper drive part 421 determines, based on the received high-level signal, that the upper power transistor Q1 needs to be driven to be turned on, the upper drive part 421 may turn on the circuit between the high-voltage signal transmission end HVDD and the high-voltage signal output end HOUTH through the first switch circuit. In this way, the voltage U_{Hupper} of the high-voltage signal transmission end HVDD may be transmitted to the control end of the upper power transistor Q1 by using the high-voltage signal output end HOUTH, to drive the upper power transistor Q1 to be turned on.

However, when the upper drive part 421 determines, based on the received low-level signal, that the upper power transistor Q1 needs to be driven to be turned off, the upper drive part 421 may turn off the circuit between the high-voltage signal transmission end HVDD and the high-voltage signal output end HOUTH through the first switch circuit. In this way, a circuit between the high-voltage signal transmission end HVDD and the control end of the upper power transistor Q1 may be turned off, to ensure that the process in which the upper drive part 421 drives the upper power transistor Q1 to be turned off is not affected by the voltage of the high-voltage signal transmission end HVDD.

In addition, the high-voltage signal transmission end HVDD is connected to the control end of the upper power transistor Q1 through the first switch circuit disposed in the upper drive part 421 and the high-voltage signal output end HOUTH, so that the driver 42 controls on/off of the circuit between the high-voltage signal transmission end HVDD and the control end of the upper power transistor Q1. Compared with a case in which the high-voltage signal transmission end HVDD is connected to the control end of the upper power transistor Q1 through a switch circuit disposed outside the driver 42, this can reduce complexity and control logic of a circuit design in the power module 40.

In some embodiments, as shown in FIG. 2, to drive the upper power transistor Q1 to be turned off, the upper drive part 421 further includes a low-voltage signal transmission end HVEE, a low-voltage signal output end HOUTL, and a second switch circuit (not shown in the figure). The low-voltage signal transmission end HVEE is connected to an end of the first power supply 43 by using the power input end VB, the low-voltage signal transmission end HVEE is further connected to the low-voltage signal output end HOUTL through the second switch circuit, and the low-voltage signal output end HOUTL is connected to the control end of the upper power transistor Q 1.

The second switch circuit is configured to: when the drive signal input end HI receives a low-level signal, turn on a circuit between the low-voltage signal transmission end HVEE and the low-voltage signal output end HOUTL. The second switch circuit is further configured to: when the drive signal input end HI receives a high-level signal, turn off a circuit between the low-voltage signal transmission end HVEE and the low-voltage signal output end HOUTL. The low-voltage signal output end HOUTL is configured to send, to the control end of the upper power transistor Q1, a signal indicates a voltage U_{Lupper} of the low-voltage signal transmission end HVEE, and the voltage U_{Lupper} of the low-voltage signal transmission end HVEE is used to drive the upper power transistor Q1 to be turned off.

Based on the foregoing design, when the drive signal input end HI receives the low-level signal, the first power supply 43 may output a voltage to the low-voltage signal transmission end HVEE by using the power input end VB, and the second switch circuit may turn on the circuit between the low-voltage signal transmission end HVEE and the low-voltage signal output end HOUTL. In this way, the voltage U_{Lupper} of the low-voltage signal transmission end HVEE may be transmitted to the control end of the upper power transistor Q1 by using the low-voltage signal output end HOUTL, to drive the upper power transistor Q1 to be turned off.

However, when the drive signal input end HI receives the high-level signal, the second switch circuit may turn off the circuit between the low-voltage signal transmission end HVEE and the low-voltage signal output end HOUTL. In this way, a circuit between the low-voltage signal transmission end HVEE and the control end of the upper power transistor Q1 may be turned off, to ensure that the process in which the upper drive part 421 drives the upper power transistor Q1 to be turned on is not affected by the voltage of the low-voltage signal transmission end HVEE.

In some embodiments, as shown in FIG. 2, the power module 40 further includes plurality of capacitors, and the plurality of capacitors include, for example, a capacitor C1, a capacitor C2, and a capacitor C3. The drive signal input end HI receives a high-level signal or a low-level signal by using one end of the capacitor C1, and the other end of the capacitor C1 is grounded. In addition, the high-voltage signal transmission end HVDD is connected, by using one end of the capacitor C2, to the first resistor R1 and the first resistor R2 that are connected in series, and the other end of the capacitor C2 is grounded. The low-voltage signal transmission end HVEE is grounded by using the capacitor C3.

Based on the foregoing design, filtering may be performed and loop stability may be maintained by using the grounded capacitor C1, the grounded capacitor C2, and the grounded capacitor C3, thereby improving reliability of running of the power module 40.

In some embodiments, as shown in FIG. 2, the power module 40 further includes a plurality of second resistors, and the plurality of second resistors include a second resistor R3, a second resistor R4, and a second resistor R5. The drive signal input end HI is connected to one end of the second resistor R3 by using one end of the capacitor C1, and the other end of the second resistor R3 is configured to receive a high-level signal or a low-level signal. In this way, impedance matching may be performed by using the second resistor R3, to reduce signal reflection and interference, thereby improving transmission quality and stability of the high-level signal and the low-level signal that are received by the drive signal input end HI.

In addition, the high-voltage signal output end HOUTH is connected to the control end of the upper power transistor Q1 by using the second resistor R4, and the low-voltage signal output end HOUTL is connected to the control end of the upper power transistor Q1 by using the second resistor R5. In this way, by using the second resistor R4 and the second resistor R5, a speed at which the high-voltage signal output end HOUTH and the low-voltage signal output end HOUTL provide a drive voltage to the control end of the upper power transistor Q1 may be adjusted, to ensure that the upper drive part 421 stably drives the upper power transistor Q1 to be turned on or off.

In some embodiments, as shown in FIG. 2, the power module 40 further includes a first magnetic device 44. The first magnetic device 44 may be a magnetic device such as an inductor, a magnetic bead, or a magnetic ring. The high-voltage signal output end HOUTH is connected to the control end of the upper power transistor Q1 by using the first magnetic device 44, and a length of a transmission line between the first magnetic device 44 and the control end of the upper power transistor Q1 is less than a length of a transmission line between the first magnetic device 44 and the high-voltage signal output end HOUTH.

It should be understood that, during specific implementation, as shown in FIG. 2, the high-voltage signal output end HOUTH may be connected to the low-voltage signal output end HOUTL, and then the high-voltage signal output end HOUTH and the low-voltage signal output end HOUTL are together connected to the control end of the upper power transistor Q1 by using the first magnetic device 44.

Based on the foregoing design, the first magnetic device 44 connected between the driver 42 and the half-bridge circuit 41 may be disposed closer to the upper power transistor Q1 in the half-bridge circuit 41. In this way, drive oscillation of the upper power transistor Q1 may be better suppressed by using the first magnetic device 44.

The foregoing describes a related structure between the upper drive part 421 in the driver 42 and the upper power transistor Q 1. The following describes a related structure between the lower drive part 422 in the driver 42 and the lower power transistor Q2.

In some embodiments, as shown in FIG. 2, the power module 40 further includes a second power supply 45, and the lower drive part 422 includes a power input end VCC and a drive signal input end LI. One end of the second power supply 45 is connected to the power input end VCC, the other end of the second power supply 45 is grounded, and the second power supply 45 is configured to supply power to the lower drive part 422 by using the power input end VCC. The drive signal input end LI is configured to receive a high-level signal or a low-level signal. The high-level signal indicates the lower drive part 422 to drive the lower power transistor Q2 to be turned on, and the low-level signal indicates the lower drive part 422 to drive the lower power transistor Q2 to be turned off.

It should be understood that, in this embodiment of this application, the second power supply 45 and the first power supply 43 may be a same power supply, or may be different power supplies.

In some embodiments, as shown in FIG. 2, the power module 40 further includes a first resistor R6, a first resistor R7, and a third switch circuit (not shown in the figure) that are connected in series, and the lower drive part 422 further includes a high-voltage signal transmission end LVDD, a high-voltage signal output end LOUTH, and a voltage output end LVFB.

The high-voltage signal transmission end LVDD is connected to an end of the second power supply 45 by using the power input end VCC, the high-voltage signal transmission end LVDD is further grounded by using the first resistor R6 and the first resistor R7 that are connected in series, and the voltage output end LVFB is connected to a connection point b between the first resistor R6 and the first resistor R7. The high-voltage signal output end LOUTH is connected to the high-voltage signal transmission end LVDD through the third switch circuit, and the high-voltage signal output end LOUTH is further connected to a control end of the lower power transistor Q2.

Based on the foregoing design, when the drive signal input end LI receives a high-level signal, the second power supply 45 may form a ground loop with the high-voltage signal transmission end LVDD, the first resistor R6, and the first resistor R7 by using the power input end VCC. The third switch circuit may turn on a circuit between the high-voltage signal transmission end LVDD and the high-voltage signal output end LOUTH, and the voltage output end LVFB may output a voltage U2 to the connection point b in the ground loop. In this case, a voltage U_{Hlower} of the high-voltage signal transmission end LVDD is equal to U2 (R6 + R7)/R7, and the voltage U_{Hlower} of the high-voltage signal transmission end LVDD may be transmitted to the control end of the lower power transistor Q2 by using the high-voltage signal output end LOUTH, to drive the lower power transistor Q2 to be turned on.

It should be understood that the related structure in which the lower drive part 422 drives the lower power transistor Q2 to be turned on is similar to the related structure in which the upper drive part 421 drives the upper power transistor Q1 to be turned on. For specific descriptions, refer to the related descriptions of the upper drive part 421. Details are not described herein again.

In some embodiments, as shown in FIG. 2, the lower drive part 422 further includes a low-voltage signal transmission end LVEE, a low-voltage signal output end LOUTL, and a fourth switch circuit (not shown in the figure). The low-voltage signal transmission end LVEE is connected to an end of the second power supply 45 by using the power input end VCC, the low-voltage signal transmission end LVEE is further connected to the low-voltage signal output end LOUTL through the fourth switch circuit, and the low-voltage signal output end LOUTL is connected to the control end of the lower power transistor Q2.

Based on the foregoing design, when the drive signal input end LI receives the low-level signal, the second power supply 45 may output a voltage to the low-voltage signal transmission end LVEE by using the power input end VCC, and the fourth switch circuit may turn on a circuit between the low-voltage signal transmission end LVEE and the low-voltage signal output end LOUTL. In this way, a voltage U_{Llower} of the low-voltage signal transmission end LVEE may be transmitted to the control end of the lower power transistor Q2 by using the low-voltage signal output end LOUTL, to drive the lower power transistor Q2 to be turned off.

It should be understood that the related structure in which the lower drive part 422 drives the lower power transistor Q2 to be turned off is similar to the related structure in which the upper drive part 421 drives the upper power transistor Q1 to be turned off. For specific descriptions, refer to the related descriptions of the upper drive part 421. Details are not described herein again.

In some embodiments, as shown in FIG. 2, the plurality of capacitors in the power module 40 further include, for example, a grounded capacitor C4, a grounded capacitor C5, and a grounded capacitor C6, and the plurality of second resistors in the power module 40 further include, for example, a second resistor R8, a second resistor R9, and a second resistor R10.

The drive signal input end LI is connected to the second resistor R8 by using an end of the capacitor C4, the high-voltage signal transmission end LVDD is connected, by using an end of the capacitor C5, to the first resistor R6 and the first resistor R7 that are connected in series, and the low-voltage signal transmission end LVEE is grounded by using the capacitor C6. In addition, the high-voltage signal output end LOUTH and the low-voltage signal output end LOUTL are connected to the control end of the lower power transistor Q2 by using the second resistor R9 and the second resistor R10, respectively. For specific descriptions, refer to the foregoing related descriptions of the capacitors C1 to C3 connected to the upper drive part 421 and the second resistors R3 to R5. Details are not described herein again.

In some embodiments, as shown in FIG. 2, the power module 40 further includes a second magnetic device 46. The high-voltage signal output end LOUTH is connected to the control end of the lower power transistor Q2 by using the second magnetic device 46, and a length of a transmission line between the second magnetic device 46 and the control end of the lower power transistor Q2 is less than a length of a transmission line between the second magnetic device 46 and the high-voltage signal output end LOUTH. In this way, the second magnetic device 46 connected between the driver 42 and the half-bridge circuit 41 may be disposed closer to the lower power transistor Q2, so that drive oscillation of the lower power transistor Q2 can be better suppressed by using the second magnetic device 46.

For specific descriptions of the second magnetic device 46, refer to the related descriptions of the first magnetic device 44. Details are not described herein again.

In some embodiments, still as shown in FIG. 2, at least one of the upper drive part 421 and the lower drive part 422 further includes a load end. For example, FIG. 2 shows an example in which the lower drive part 422 further includes a load end LDO5. The load end LDO5 is grounded through a load 47 in the power module 40. In addition, the load end LDO5 is configured to receive, by using the power input end VCC in the lower drive part 422 in which the load end LDO5 is located, a voltage that is output by the second power supply 45, and transmit the received voltage to the load 47, to supply power to the load 47. The voltage transmitted by the load end LDO5 to the load 47 may be, for example, 5 V.

It should be understood that, in this embodiment of this application, the load 47 may be an electrical apparatus that is in the power module 40 and that is located outside the driver 42, for example, may be a digital signal processor that is in the power module 40 and that is located near the driver 42.

Based on the foregoing design, the driver 42 may be used as a power supply, and supplies power to the load 47 near the driver 42 by using the load end disposed on the driver. In this way, this not only facilitates power supply to the load 47, but also may increase a utilization rate of the driver 42.

In some embodiments, still as shown in FIG. 2, the plurality of capacitors in the power module 40 further include a capacitor C7. The capacitor C7 and the load 47 are connected in parallel, and the load end LDO5 is grounded by using the capacitor C7 and the load 47 that are connected in parallel. In this way, filtering may be performed by using the capacitor C7, to ensure reliable running of the load end LDO5 supplying power to the load 47.

It should be understood that, in the embodiment shown in FIG. 2, an example in which the half-bridge circuit 41 includes a group of two serially connected power transistors is used, that is, an example in which the half-bridge circuit 41 includes the upper power transistor Q1 and the lower power transistor Q2 that are connected in series is used, to describe a related structure in which the driver 42 drives the half-bridge circuit 41. In some other embodiments, the half-bridge circuit 41 may alternatively include a plurality of groups of two serially connected power transistors, the plurality of groups of two serially connected power transistors are connected in parallel, and a plurality of connection points formed between the two power transistors in the plurality of groups of two serially connected power transistors are connected. In this case, a manner in which the driver 42 drives each group of two serially connected power transistors is the same as a manner in which the driver 42 drives the upper power transistor Q1 and the lower power transistor Q2 that are connected in series shown in FIG. 2.

The following provides descriptions by using an example in which the driver 42 drives two groups of two serially connected power transistors in the half-bridge circuit 41.

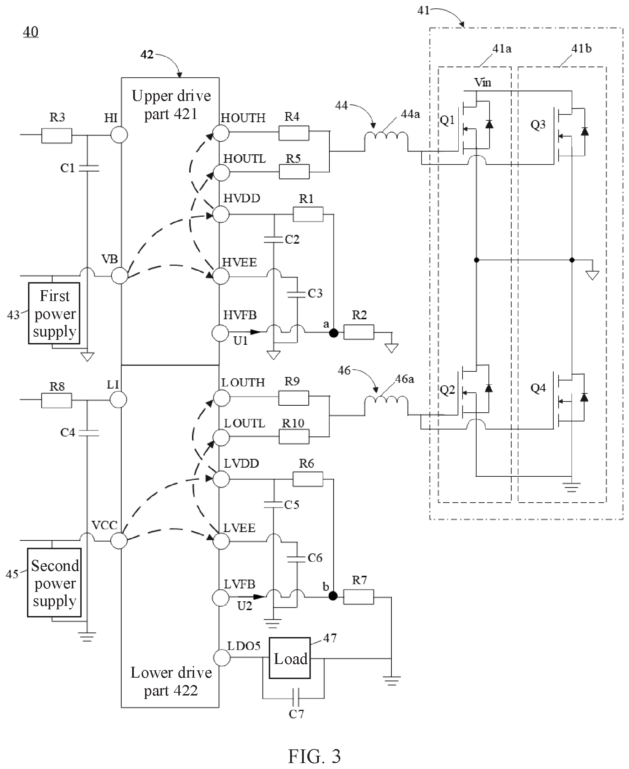

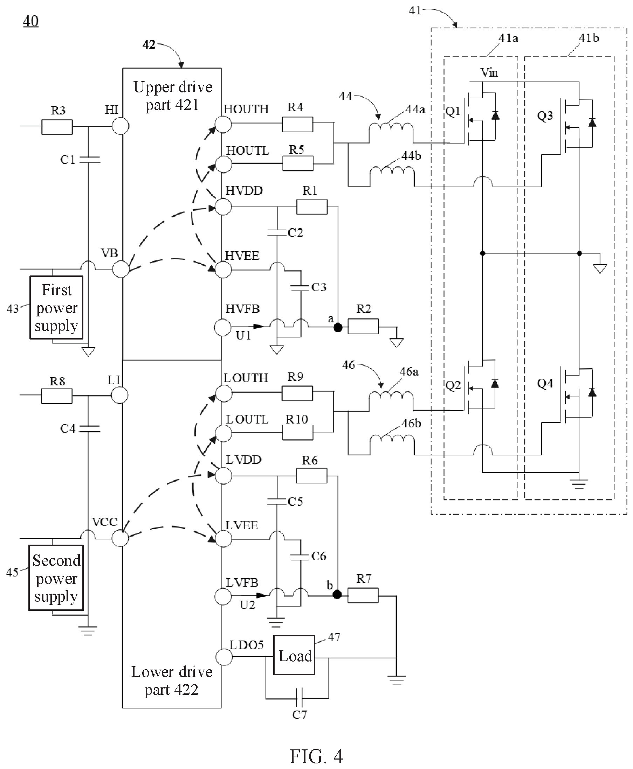

FIG. 3 and FIG. 4 are respectively diagrams of structures of another power module 40 according to embodiments of this application.

In some embodiments, with reference to FIG. 3 and FIG. 4, a half-bridge circuit 41 includes two groups of two serially connected power transistors. That is, in addition to an upper power transistor Q1 and a lower power transistor Q2 that are connected in series, the half-bridge circuit 41 further includes an upper power transistor Q3 and a lower power transistor Q4 that are connected in series. For ease of description, the upper power transistor Q1 and the lower power transistor Q2 that are connected in series are denoted as a power transistor group 41a, and the upper power transistor Q3 and the lower power transistor Q4 that are connected in series are denoted as a power transistor group 41b.

The power transistor group 41a and the power transistor group 41b are connected in parallel, and a connection point between the upper power transistor Q1 and the lower power transistor Q2 is connected to a connection point between the upper power transistor Q3 and the lower power transistor Q4. That is, a source of the upper power transistor Q1 and a source of the upper power transistor Q3 are connected to a same reference ground, and a source of the lower power transistor Q2 and a source of the lower power transistor Q4 are connected to a same reference ground.

In addition, a high-voltage signal output end HOUTH and a low-voltage signal output end HOUTL in an upper drive part 421 may be connected to a control end of the upper power transistor Q1 and a control end of the upper power transistor Q3, to drive the upper power transistor Q1 and the upper power transistor Q3 to be turned on or off. A high-voltage signal output end LOUTH and a low-voltage signal output end LOUTL in a lower drive part 422 may be connected to a control end of the lower power transistor Q2 and a control end of the lower power transistor Q4, to drive the lower power transistor Q2 and the lower power transistor Q4 to be turned on or off.

It should be understood that, during specific implementation, a manner in which the upper drive part 421 drives the upper power transistor Q3 to be turned on or off is the same as a manner in which the upper drive part 421 drives the upper power transistor Q1 to be turned on or off, and a manner in which the lower drive part 422 drives the lower power transistor Q4 to be turned on or off is the same as a manner in which the lower drive part 422 drives the lower power transistor Q2 to be turned on or off. For specific descriptions, refer to related descriptions in the embodiment shown in FIG. 2. Details are not described herein again.

In some embodiments, as shown in FIG. 3, when the half-bridge circuit 41 includes a plurality of groups of two serially connected power transistors, there may be one first magnetic device 44. The high-voltage signal output end HOUTH in the upper drive part 421 may be connected, by using the first magnetic device 44, to a control end of an upper power transistor in each group of two serially connected power transistors.

For example, as shown in FIG. 3, when the half-bridge circuit 41 includes a power transistor group 41a and a power transistor group 41b, the power module 40 includes one first magnetic device 44, that is, includes a first magnetic device 44a. The high-voltage signal output end HOUTH may be connected to the low-voltage signal output end HOUTL, and then connected to the control end of the upper power transistor Q1 in the power transistor group 41a and the control end of the upper power transistor Q3 in the power transistor group 41b by using the first magnetic device 44a. In addition, a length of a transmission line between the first magnetic device 44a and the control end of the upper power transistor Q1 and a length of a transmission line between the first magnetic device 44a and the control end of the upper power transistor Q3 are both less than a length of a transmission line between the first magnetic device 44a and the high-voltage signal output end HOUTH.

Based on the foregoing design, the high-voltage signal output end HOUTH may be connected, by using the first magnetic device 44, to the upper power transistor in each group of two serially connected power transistors in the half-bridge circuit 41, and the first magnetic device 44 is disposed closer to the upper power transistor in each group of two serially connected power transistors. In this way, not only drive oscillation of the upper power transistor in each group of two serially connected power transistors may be better suppressed by using the first magnetic device 44, but also oscillation crosstalk generated between the plurality of groups that are connected in parallel and that are of two serially connected power transistors can be suppressed. In addition, a small quantity of first magnetic devices 44 may be used in the power module 40, thereby facilitating cost optimization of the power module 40.

In some other embodiments, as shown in FIG. 4, when the half-bridge circuit 41 includes a plurality of groups of two serially connected power transistors, there may be a plurality of first magnetic devices 44. The high-voltage signal output end HOUTH in the upper drive part 421 may be connected, by using one first magnetic device 44, to a control end of an upper power transistor in a group of two serially connected power transistors. That is, the plurality of first magnetic devices are in a one-to-one correspondence with the plurality of groups of two serially connected power transistors, and the high-voltage signal output end HOUTH is connected, by using each first magnetic device 44, to a control end of an upper power transistor in a group that is of two serially connected power transistors and that is corresponding to each first magnetic device 44.

For example, as shown in FIG. 4, when the half-bridge circuit 41 includes a power transistor group 41a and a power transistor group 41b, the power module 40 may include two first magnetic devices 44, that is, includes a first magnetic device 44a and a first magnetic device 44b. The high-voltage signal output end HOUTH may be connected to the low-voltage signal output end HOUTL and then connected to the control end of the upper power transistor Q1 in the power transistor group 41a by using the first magnetic device 44a, and a length of a transmission line between the first magnetic device 44a and the control end of the upper power transistor Q1 is less than a length of a transmission line between the first magnetic device 44a and the high-voltage signal output end HOUTH.

Similarly, the high-voltage signal output end HOUTH may further be connected to the low-voltage signal output end HOUTL and then connected to the control end of the upper power transistor Q3 in the power transistor group 41b by using the first magnetic device 44b, and a length of a transmission line between the first magnetic device 44b and the control end of the upper power transistor Q3 is less than a length of a transmission line between the first magnetic device 44b and the high-voltage signal output end HOUTH.

Based on the foregoing design, the high-voltage signal output end HOUTH may be separately connected, by using the plurality of first magnetic devices 44, to upper power transistors in the plurality of groups of two serially connected power transistors, and each first magnetic device 44 is disposed closer to an upper power transistor connected to the first magnetic device 44. In this way, not only drive oscillation of the upper power transistor in each group of two serially connected power transistors may be better suppressed by using the plurality of first magnetic devices 44, but also oscillation crosstalk generated between the plurality of groups that are connected in parallel and that are of two serially connected power transistors can be suppressed. In addition, because the upper power transistor in each group of two serially connected power transistors is connected to different first magnetic devices 44, normal operation of another first magnetic device 44 may be prevented from being affected because a fault occurs on one first magnetic device 44.

In some embodiments, as shown in FIG. 3, when the half-bridge circuit 41 includes a plurality of groups of two serially connected power transistors, similar to the power module 40 including one first magnetic device 44, the power module 40 may alternatively include one second magnetic device 46, for example, include a second magnetic device 46a. In this way, the high-voltage signal output end LOUTH in the lower drive part 422 may be connected, by using the second magnetic device 46a, to a control end of a lower power transistor in each group of two serially connected power transistors in the power module 40. For specific descriptions, refer to the related descriptions of the first magnetic device 44a shown in FIG. 3. Details are not described herein again.

In some other embodiments, as shown in FIG. 4, when the half-bridge circuit 41 includes a plurality of groups of two serially connected power transistors, similar to the power module 40 including a plurality of first magnetic devices 44, the power module 40 may alternatively include a plurality of second magnetic devices 46, and the high-voltage signal output end LOUTH may be connected, by using one second magnetic device 46, to a control end of a lower power transistor in a group of two serially connected power transistors. For example, as shown in FIG. 4, the power module includes a second magnetic device 46a and a second magnetic device 46b. The high-voltage signal output end LOUTH is connected to the control end of the lower power transistor Q2 in the power transistor group 41a by using the second magnetic device 46a, and the high-voltage signal output end LOUTH is further connected to the control end of the lower power transistor Q4 in the power transistor group 41b by using the second magnetic device 46b. For specific descriptions, refer to the related descriptions of the first magnetic device 44a and the first magnetic device 44b shown in FIG. 4.

It should be understood that, in the power module 40 provided in this embodiment of this application, there may be one or more half-bridge circuits 41 and one or more drivers 42. The one or more half-bridge circuits 41 form a power conversion circuit in the power module 40. For specific descriptions of the power conversion circuit, refer to the related descriptions in the embodiment shown in FIG. 1. Details are not described herein again. In addition, the one or more half-bridge circuits 41 are in a one-to-one correspondence with the one or more drivers 42, and each of the drivers 42 is configured to drive a corresponding half-bridge circuit 41.

An embodiment of this application further provides a power supply device. The power supply device includes a plurality of power modules 40 described in the foregoing embodiments, the plurality of power modules 40 are connected in parallel, and the plurality of power modules 40 are configured to supply power to a load.

It should be understood that, in this embodiment of this application, the power supply device may be a device configured to provide electric energy in a scenario such as a communication base station, a data center, a charging station, an energy storage system, or a photovoltaic system. For specific descriptions, refer to the related descriptions in the embodiment shown in FIG. 1. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a half-bridge circuit and a driver, the half-bridge circuit comprises two serially connected power transistors, the two power transistors do not share a ground, the driver comprises two drive parts, one of the drive parts is configured to drive one of the power transistors, and a circuit in which the one drive part is located shares a ground with the one corresponding power transistor; and
the power module further comprises two first resistors connected in series and a power supply, and each drive part comprises a power input end, a high-voltage signal transmission end, and a voltage output end, wherein
one end of the power supply is connected to the high-voltage signal transmission end by using the power input end, the other end of the power supply is grounded, the high-voltage signal transmission end is further grounded by using the two first resistors connected in series, and a voltage of the high-voltage signal transmission end is used to drive the one of the power transistors to be turned on; and
the voltage output end is connected to a connection point between the two first resistors connected in series, and the voltage output end is configured to output a voltage to the connection point.

2. The power module according to claim 1, wherein at least one of the drive parts further comprises a load end, and the load end is grounded by using a load in the power module; and
the load end is configured to receive, by using a power input end in the drive part in which the load end is located, a voltage that is output by the power supply, and transmit the received voltage to the load.

3. The power module according to claim 1 or 2, wherein each drive part further comprises a high-voltage signal output end, a first switch circuit, and a drive signal input end, the high-voltage signal output end is connected to the high-voltage signal transmission end through the first switch circuit, and the high-voltage signal output end is further connected to a control end of the one the power transistor;
the high-voltage signal output end is configured to send, to the one power transistor, a signal indicating a voltage of the high-voltage signal transmission end; and
the first switch circuit is configured to:
when the drive signal input end receives a high-level signal, turn on a circuit between the high-voltage signal output end and the high-voltage signal transmission end; or
when the drive signal input end receives a low-level signal, turn off a circuit between the high-voltage signal output end and the high-voltage signal transmission end.

4. The power module according to claim 3, wherein the power module further comprises a magnetic device, and the high-voltage signal output end is connected to the control end of the one power transistor by using the magnetic device; and
a length of a transmission line between the magnetic device and the control end of the one power transistor is less than a length of a transmission line between the magnetic device and the high-voltage signal output end.

5. The power module according to claim 4, wherein the half-bridge circuit comprises a plurality of groups of two serially connected power transistors, the plurality of groups of two serially connected power transistors are connected in parallel, and a plurality of connection points formed between the two power transistors in the plurality of groups of two serially connected power transistors are connected;
there is one magnetic device, and the high-voltage signal output end is connected to the control end of one of the power transistors in each group of two power transistors by using the magnetic device; and
a length of a transmission line between the magnetic device and each control end connected to the magnetic device is less than a length of a transmission line between the magnetic device and the high-voltage signal output end.

6. The power module according to claim 4, wherein the half-bridge circuit comprises a plurality of groups of two serially connected power transistors, the plurality of groups of two serially connected power transistors are connected in parallel, and a plurality of connection points formed between the two power transistors in the plurality of groups of two serially connected power transistors are connected;
there are a plurality of magnetic devices, and the high-voltage signal output end is connected to the control end of the one power transistor in one group of power transistors by using one of the magnetic devices; and
a length of a transmission line between the one magnetic device and the control end connected to the one magnetic device is less than a length of a transmission line between the one magnetic device and the high-voltage signal output end.

7. The power module according to any one of claims 3 to 6, wherein each drive part further comprises a low-voltage signal output end, a low-voltage signal transmission end, and a second switch circuit, wherein
the low-voltage signal transmission end is connected to the one end of the power supply by using the power input end, the low-voltage signal transmission end is further connected to the low-voltage signal output end through the second switch circuit, and the low-voltage signal output end is connected to the control end of the one power transistor;
the low-voltage signal output end is configured to send, to the one power transistor, a signal indicating a voltage of the low-voltage signal transmission end, wherein the voltage of the low-voltage signal transmission end is used to drive one of the power transistors to be turned off; and
the second switch circuit is configured to:
when the drive signal input end receives a low-level signal, turn on a circuit between the low-voltage signal transmission end and the low-voltage signal output end; or
when the drive signal input end receives a high-level signal, turn off the circuit between the low-voltage signal transmission end and the low-voltage signal output end.

8. The power module according to claim 7, wherein the power module further comprises a plurality of capacitors, wherein
the high-voltage signal transmission end is connected, by using one end of one of the capacitors, to the two first resistors connected in series, and the other end of the one capacitor is grounded; and
the low-voltage signal transmission end is grounded by using another capacitor.

9. The power module according to claim 7 or 8, wherein the power module further comprises a plurality of second resistors, and the high-voltage signal output end and the low-voltage signal output end are separately connected to the control end of the one power transistor by using one of the second resistors.

10. A power supply device, wherein the power supply device comprises a plurality of power modules according to any one of claims 1 to 9, the plurality of power modules are connected in parallel, and the plurality of power modules are configured to supply power to a load.
